# EUROPEAN PATENT APPLICATION

(11) **EP 4 845 338 A1**
(43) Date of publication of application: **25.11.2026**
(21) Application number: 26180223.5
(22) Date of filing: 21.05.2026
(51) Int. Cl.: H10D 30/69, H10D 30/00, H10D 30/01, H10D 30/43, H10D 62/13

(54) **SEMICONDUCTOR DEVICE AND MANUFACTURING METHOD OF THE SAME**

(30) Priority: 23.05.2025 KR 20250067766
(71) Applicant: Samsung Electronics Co., Ltd., Suwon-si, Gyeonggi-do 16677 (KR)
(72) Inventor: LEE, Sangmoon, 16677 Suwon-si (KR); KIM, Yihwan, 16677 Suwon-si (KR)
(74) Representative: Marks & Clerk LLP

(57) **Abstract**

A semiconductor device includes source/drain patterns on a substrate, a channel pattern connected to the source/drain patterns, a gate electrode on the channel pattern, and a barrier layer provided between the substrate and the source/drain patterns and between the channel pattern and the source/drain patterns. The barrier layer contains a metal oxide.

## Description

### BACKGROUND

The present disclosure relates to a semiconductor device and a manufacturing method of the same, and more particularly, to a semiconductor device including a field-effect transistor and a manufacturing method of the same.

A semiconductor device includes integrated circuits composed of Metal Oxide Semiconductor Field-Effect Transistors (MOSFETs). As the size and design rule of semiconductor devices are gradually reduced, the scale down of the MOSFETs is also being increasingly accelerated. The operating characteristics of semiconductor devices may be deteriorated due to the scale down of MOSFETs. Accordingly, various methods are being studied to form the semiconductor devices with excellent performance while overcoming the limitations due to high integration of the semiconductor devices.

### SUMMARY

An object of the present invention is directed to providing a field-effect transistor semiconductor device capable of providing stable performance and improved reliability.

A semiconductor device according to one embodiment of the present invention may include source/drain patterns on a substrate, a channel pattern connected to the source/drain patterns, a gate electrode on the channel pattern, and a barrier layer provided between the substrate and the source/drain patterns and between the channel pattern and the source/drain patterns, the barrier layer containing a metal oxide.

In the semiconductor device, at least a portion of the barrier layer may be a crystalline layer epitaxially grown from the substrate and/or the channel pattern.

In the semiconductor device, the substrate may contain silicon, and the metal oxide may contain a metal having oxygen reactivity higher than that of the silicon.

In the semiconductor device, the substrate may contain silicon, and the metal oxide may have a bandgap greater than that of the silicon.

In the semiconductor device, a metal of the metal oxide may be aluminum or nickel.

In the semiconductor device, the barrier layer may include a first barrier layer provided between the substrate and the source/drain patterns and a second barrier layer provided between the channel pattern and the source/drain patterns.

In the semiconductor device, the first barrier layer and the second barrier layer may be integrally formed as an undivided structure.

In the semiconductor device, a thickness of the first barrier layer may be larger than a thickness of the second barrier layer.

In the semiconductor device, a metal concentration of the first barrier layer may be greater than a metal concentration of the second barrier layer.

In the semiconductor device, the metal concentration of the second barrier layer may be 50% or less of the metal concentration of the first barrier layer.

The semiconductor device may further include a metal doped layer provided on the substrate, wherein the first barrier layer may be provided between the metal doped layer and the source/drain patterns.

In the semiconductor device, the metal doped layer may contain a same metal as a metal of the metal oxide.

In the semiconductor device, at least one of the source/drain patterns may include a first epitaxial layer having a first impurity concentration, and a second epitaxial layer having a second impurity concentration different from the first impurity concentration.

In the semiconductor device, the source/drain patterns may include first source/drain patterns containing a P-type impurity, and second source/drain patterns containing an N-type impurity.

In the semiconductor device, the second source/drain patterns may contain the same semiconductor element as that of the substrate, and the first source/drain patterns may contain a semiconductor element having a lattice constant greater than a lattice constant of the semiconductor element of the substrate.

In the semiconductor device, the channel pattern may include a plurality of semiconductor patterns vertically stacked and spaced apart from each other.

In the semiconductor device, the gate electrode may surround each of the semiconductor patterns.

A semiconductor device according to one embodiment of the present invention may include a metal doped layer on a substrate, source/drain patterns provided on the metal doped layer, a channel pattern connected to the source/drain patterns, a gate electrode on the channel pattern, and a barrier layer surrounding a lower portion and side portions of each of the source/drain patterns, wherein the barrier layer may contain an oxide of a metal having a bandgap and oxygen reactivity that are greater than those of the substrate.

A semiconductor device according to one embodiment of the present invention may include first and second transistors provided in different regions, wherein each of the first and second transistors may include source/drain patterns on a substrate, a channel pattern connected to the source/drain patterns, a gate electrode on the channel pattern, and a barrier layer provided between the substrate and the source/drain patterns and between the channel pattern and the source/drain patterns, and barrier layer containing a metal oxide, and wherein the source/drain patterns of the first transistor may be doped with impurities of a conductivity type different from that of the source/drain patterns of the second transistor.

In the semiconductor device, the first transistor may be a PMOS transistor and the second transistor may be an NMOS transistor.

A manufacturing method of a semiconductor device according to one embodiment of the present invention may include forming a metal doped layer on a substrate, forming a preliminary stacked pattern by alternately stacking first and second semiconductor layers on the metal doped layer, forming a stacked pattern by forming recesses in the metal doped layer and the preliminary stacked pattern, forming a barrier layer containing a metal oxide in the recesses, forming source/drain patterns in the recesses in which the barrier layer is formed, selectively etching the first semiconductor layers to form recesses, forming a gate insulating layer in the recesses, and forming a gate electrode on the gate insulating layer.

In one embodiment, the forming of the barrier layer may include an epitaxial growth process.

In one embodiment, the forming of the source/drain patterns may be performed by an epitaxial growth process.

In one embodiment, the forming of the barrier layer may include forming a first preliminary barrier layer containing a metal in the recesses, oxidizing the first preliminary barrier layer to form a second preliminary barrier layer, and removing a portion of the second preliminary barrier layer to form the barrier layer.

In one embodiment, the forming of the first preliminary barrier layer may be performed by an epitaxial growth process.

In one embodiment, the first preliminary barrier layer may be oxidized by a dry thermal oxidation process.

In one embodiment, the substrate may contain silicon, and the metal oxide may contain a metal having oxygen reactivity higher than that of the silicon.

In one embodiment, the metal of the metal doped layer and the metal in the metal oxide contained in the barrier layer may be the same.

In one embodiment, the barrier layer may include a first barrier layer covering lower portions of the recesses and a second barrier layer covering side portions of the recesses. In one embodiment, a thickness of the first barrier layer may be larger than a thickness of the second barrier layer.

At least some of the above and other features of the invention are set out in the claims.

### BRIEF DESCRIPTION OF DRAWINGS

FIG. 1 is a plan view for explaining a semiconductor device according to some embodiments of the present disclosure.
FIG. 2A is a pair of cross-sectional views taken along lines A-A' and B-B' of FIG. 1, and FIG. 2B is a cross-sectional view taken along line C-C' of FIG. 1.
FIG. 3 is an enlarged cross-sectional view of portion P1 of FIG. 2A.
FIGS. 4A to 15B sequentially show a manufacturing method of the semiconductor device according to one embodiment of the present invention, wherein FIGS. 4A, 5A, 6 to 10, 11A, 12A, 13A, 14A, and 15 are cross-sectional views taken along line A-A' and line B-B' of FIG. 1, and FIGS. 4B, 5B, 11B, 12B, 13B, and 14B are cross-sectional views taken along line C-C' of FIG. 1.

### DETAILED DESCRIPTION

Hereafter, embodiments of the present disclosure will be clearly and thoroughly described with reference to the accompanying drawings.

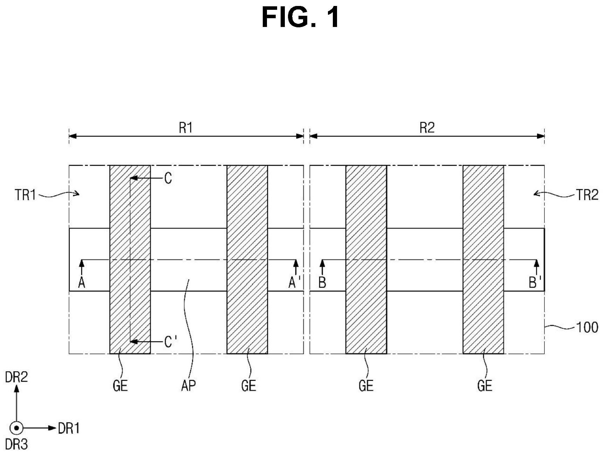

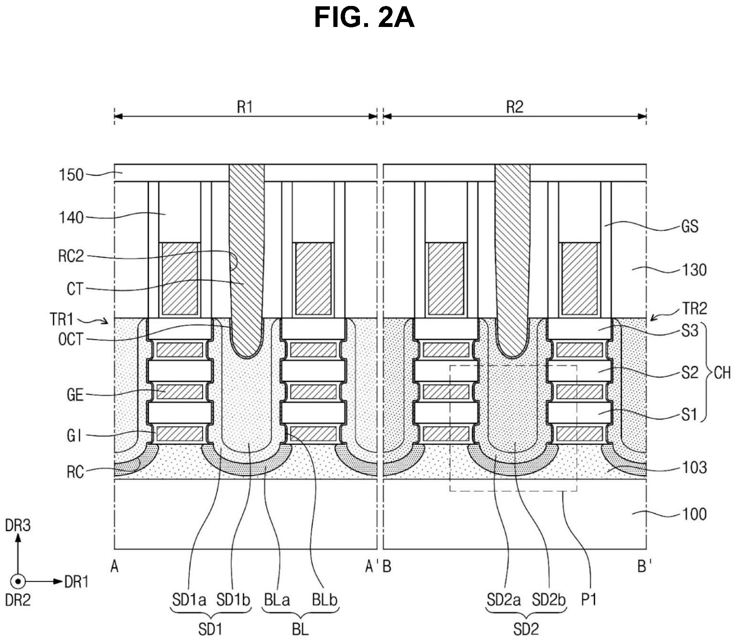

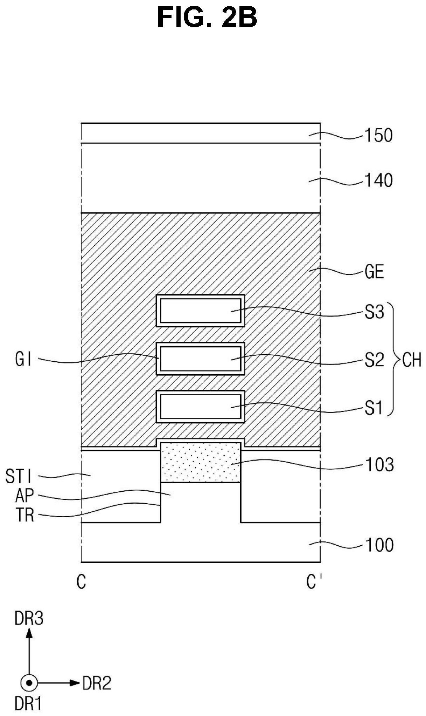

FIG. 1 is a plan view for explaining a semiconductor device according to some embodiments of the present disclosure. FIG. 2A is a pair of cross-sectional views taken along lines A-A' and B-B' of FIG. 1, and FIG. 2B is a cross-sectional view taken along line C-C' of FIG. 1.

Referring to FIGS. 1, 2A, and 2B, the semiconductor device may include a substrate 100 and a plurality of transistors disposed on the substrate 100.

In one embodiment, the plurality of transistors may be transistors used in various electronic devices. For example, the plurality of transistors may form various types of electronic circuits, and may be, for example, logic transistors forming logic circuits.

In one embodiment, the semiconductor device may include at least one of a PMOSFET region and an NMOSFET region. In one embodiment, the semiconductor device may include a first region R1 and a second region R2, wherein the first region R1 may be one of the PMOSFET region and the NMOSFET region, and the second region R2 may be the other one of the PMOSFET region and the NMOSFET region. Hereinafter, an example in which the first region R1 is the PMOSFET region and the second region R2 is the NMOSFET region will be described.

The semiconductor device may include a plurality of active patterns AP protruding from the substrate 100 in a vertical direction (a third direction DR3) and extending in a first horizontal direction (a first direction DR1), metal doped layers 103 provided on the active patterns AP, and the plurality of transistors provided on the metal doped layers 103. Here, a second direction DR2, which is not described above, is a direction perpendicular to each of the first direction DR1 and the third direction DR3.

The plurality of transistors may include at least one first transistor TR1 disposed in the first region R1 and at least one second transistor TR2 disposed in the second region R2. The first transistor TR1 may be a PMOS transistor, and the second transistor TR2 may be an NMOS transistor.

The substrate 100 may contain a semiconductor such as Si or Ge, or a compound semiconductor such as SiGe, SiC, GaAs, InAs, InGaAs, or InP. As used in the present specification, the terms "SiGe," "SiC," "GaAs," "InAs," "InGaAs," and "InP" refer to materials made of the elements included in each term and are not chemical formulas representing stoichiometric relationships. In one example, the substrate 100 may be a silicon substrate.

A shallow trench isolation pattern STI defining the active pattern AP may be provided on the substrate 100. The shallow trench isolation pattern STI may fill a trench TR. The shallow trench isolation pattern STI may contain silicon oxide. The shallow trench isolation pattern STI may not cover the active pattern AP.

The metal doped layer 103 may be provided on the substrate 100. The metal doped layer 103 may be a layer epitaxially grown on the active pattern AP and may contain metal impurities. The metal doped layer 103 may vertically overlap the active patterns AP. In a plan view, the metal doped layer 103 may have substantially the same shape as the active patterns AP.

The first transistor TR1 and the second transistor TR2 may be provided on the metal doped layer 103.

The first transistor TR1 may include at least one channel pattern CH disposed on the metal doped layer 103 in the first region R1, at least a pair of first source/drain patterns SD1 disposed on both sides of the channel pattern CH in the first direction DR1, and a gate electrode GE provided on the channel pattern CH.

The second transistor TR2 may include at least one channel pattern CH disposed on the metal doped layer 103 in the second region R2, at least a pair of second source/drain patterns SD2 disposed on both sides of the channel pattern CH, and a gate electrode GE provided on the channel pattern CH.

Each channel pattern CH in the first and second regions R1 and R2 may include semiconductor patterns that are sequentially stacked. The semiconductor patterns may be spaced apart from each other. In one embodiment, the channel patterns CH may include first to third semiconductor patterns S1, S2, and S3 that are spaced apart from each other and vertically stacked. However, the number of semiconductor patterns in the channel pattern CH is not limited thereto and may be provided in various numbers, for example, 1, 2, or 4 or more.

In embodiments, the first to third semiconductor patterns S1, S2, and S3 of the first transistor TR1 and the first to third semiconductor patterns S1, S2, and S3 of the second transistor TR2 may be formed of semiconductor layers made of the same elements. For example, each of the first to third semiconductor patterns S1, S2, and S3 of the first transistor TR1 and the second transistor TR2 may contain silicon (Si), germanium (Ge), or silicon-germanium (SiGe). For example, each of the first to third semiconductor patterns S1, S2, and S3 may contain crystalline silicon.

The first to third semiconductor patterns S1, S2, and S3 of the first transistor TR1 and the first to third semiconductor patterns S1, S2, and S3 of the second transistor TR2 may be formed of doped or undoped semiconductor layers. In one example, each of the first to third semiconductor patterns S1, S2, and S3 of the first and second transistors TR1 and TR2 may be formed of an undoped Si layer. In other embodiments, each of the first to third semiconductor patterns S1, S2, and S3 of the first transistor TR1 may be formed of a Si layer doped with impurities having the same conductivity type as that of the first source/drain pattern SD1, and each of the first to third semiconductor patterns S1, S2, and S3 of the second transistor TR2 may be formed of a Si layer doped with impurities having the same conductivity type as that of the second source/drain pattern SD2. In still other embodiments, the first to third semiconductor patterns S1, S2, and S3 of the first transistor TR1 may each be formed of Si layers doped with impurities having an opposite conductivity type from that of the first source/drain pattern SD1, and the first to third semiconductor patterns S1, S2, and S3 of the second transistor TR2 may each be formed of Si layers doped with impurities having an opposite conductivity type from that of the second source/drain pattern SD2.

The gate electrode GE may be provided on the first to third semiconductor patterns S1, S2, and S3 of the channel pattern CH. The gate electrode GE may be vertically stacked with the first to third semiconductor patterns S1, S2, and S3 of the channel pattern CH. Specifically, the gate electrode GE may be alternately stacked with the first to third semiconductor patterns S1, S2, and S3 of the channel pattern CH in the third direction DR3. More specifically, the gate electrode GE may be interposed between the first to third semiconductor patterns S1, S2, and S3 of the channel pattern CH, disposed over the uppermost one of the first to third semiconductor patterns S1, S2, and S3 of the channel pattern CH, and disposed under the lowermost one of the first to third semiconductor patterns S1, S2, and S3 of the channel pattern CH. Therefore, the gate electrode GE may vertically overlap the channel pattern CH.

The gate electrode GE may surround the channel pattern CH. The gate electrode GE may surround each of the first to third semiconductor patterns S1, S2, and S3 of the channel pattern CH. In other words, the gate electrode GE may be provided on an upper surface, a lower surface, a front surface, and a rear surface of each of the first to third semiconductor patterns S1, S2, and S3. Accordingly, the transistor according to the present embodiments may be a three-dimensional field-effect transistor (e.g., a multi-bridge channel field-effect transistor (MBCFET) or a gate-all-around field-effect transistor (GAAFET)) in which the gate electrode GE three-dimensionally surrounds the channel pattern CH.

The gate electrode GE may planarly extend on an upper surface of the substrate 100. In one embodiment, the gate electrode GE may extend in the second direction DR2.

The gate electrode GE may be made of a metal, a metal nitride, a metal carbide, or a combination thereof. The metal may be selected from Ti, W, Ru, Nb, Mo, Hf, Ni, Co, Pt, Yb, Tb, Dy, Er, and Pd. The metal nitride may be selected from TiN and TaN. The metal carbide may be TiAlC. However, the material constituting the gate electrode GE is not limited to the above examples.

A gate insulating layer GI may be provided between the gate electrode GE and the first to third semiconductor patterns S1, S2, and S3. The gate insulating layer GI may be provided on the first to third semiconductor patterns S1, S2, and S3 and may surround each of the first to third semiconductor patterns S1, S2, and S3. In other words, the gate insulating layer GI may be provided on the upper surface, the lower surface, the front surface, and the rear surface of each of the first to third semiconductor patterns S1, S2, and S3. The gate insulating layer GI may be in contact with the first to third semiconductor patterns S1, S2, and S3.

The gate insulating layer GI may planarly extend on the upper surface of the substrate 100. The gate insulating layer GI may be in contact with an upper surface of the metal doped layer 103. The gate insulating layer GI may be disposed between the upper surface of the substrate 100 and the gate electrode GE.

The gate insulating layer GI may include an interface layer and a high-k dielectric layer. The interface layer may contain at least one of silicon oxide and silicon oxynitride. The high-k dielectric layer may contain a high-k material having a dielectric constant higher than that of silicon oxide. In one embodiment, the high-k dielectric layer may contain at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanate, barium titanate, strontium titanate, lithium oxide, aluminum oxide, lead scandium tantalate, and lead zinc niobate.

Although not shown, a diffusion barrier pattern may be provided on the gate insulating layer GI. The diffusion barrier pattern may also be disposed between the gate insulating layer GI and the gate electrode GE. That is, the diffusion barrier pattern may separate the gate insulating layer GI from the gate electrode GE. Therefore, the gate insulating layer GI may not be in direct contact with the gate electrode GE. The diffusion barrier pattern may be disposed between the gate insulating layer GI and the gate electrode GE. The diffusion barrier pattern may reduce material exchange between the gate electrode GE and the gate insulating layer GI. For example, the diffusion barrier pattern may minimize the phenomenon of a metal element contained in the gate electrode GE diffusing into the gate insulating layer GI.

The first source/drain patterns SD1 constituting the first transistor TR1 may each fill recesses RC formed on the active pattern AP. The second source/drain patterns SD2 constituting the second transistor TR2 may each fill recesses RC formed on the active pattern AP.

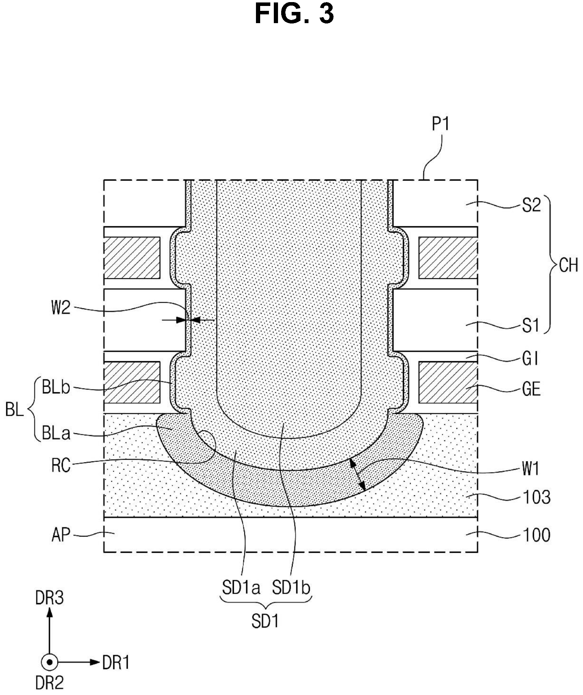

A barrier layer BL may be provided on the perimeters of the first and second source/drain patterns SD1 and SD2. The barrier layer BL may include a first barrier layer BLa provided on a lower portion of the first and second source/drain patterns SD1 and SD2, and a second barrier layer BLb provided on side portions of the first and second source/drain patterns SD1 and SD2. The barrier layer BL may contain a metal oxide, and may be a crystalline layer epitaxially grown from the metal doped layer 103 and/or the channel pattern CH. The barrier layer BL will be described below with reference to FIG. 3.

In the first region R1, the first source/drain patterns SD1 may be provided on both sides of the channel pattern CH. The channel pattern CH may connect the first source/drain patterns SD1 on both of its sides in the first direction DR1 to each other. Specifically, the first to third semiconductor patterns S1, S2, and S3 may be connected to the first source/drain patterns SD1 located on both sides thereof.

In the second region R2, the second source/drain patterns SD2 may be provided on both sides of the channel pattern CH, and the channel pattern CH may connect the second source/drain patterns SD2 on both of its sides to each other. Specifically, the second to third semiconductor patterns S2 and S3 may be connected to the second source/drain patterns SD2 located on both sides thereof.

The first source/drain pattern SD1 and the second source/drain pattern SD2 may each be formed of an epitaxially grown semiconductor layer. In embodiments, the first source/drain pattern SD1 and the second source/drain pattern SD2 may each be formed of a group IV element semiconductor, a group IV-IV compound semiconductor, or a combination thereof.

In one embodiment, the first source/drain pattern SD1 and the second source/drain pattern SD2 may be doped with different conductivity types depending on the types of the first and second transistors TR1 and TR2. The first source/drain pattern SD1 may be doped with a first conductivity type impurity, and the second source/drain pattern SD2 may be doped with a second conductivity type impurity opposite to the first conductivity type. For example, the first conductivity type may be a P-type, and the second conductivity type may be an N-type. In another example, the first source/drain pattern SD1 may be an N-type impurity region, and the second source/drain pattern SD2 may be a P-type impurity region. The P-type impurity may be selected from boron (B) and gallium (Ga). The N-type impurity may be selected from phosphorus (P), arsenic (As), and antimony (Sb).

Each first source/drain pattern SD1 may include first and second epitaxial layers SD1a and SD1b having different impurity concentrations. The second epitaxial layer SD1b may have an impurity concentration higher than that of the first epitaxial layer SD1a. Each second source/drain pattern SD2 may also include first and second epitaxial layers SD2a and SD2b having different impurity concentrations. The second epitaxial layer SD2b of each second source/drain pattern SD2 may have an impurity concentration higher than that of the first epitaxial layer SD2a.

In one embodiment, when the first transistor TR1 is a PMOS transistor, the first source/drain patterns SD1 may contain silicon germanium (SiGe), and a germanium concentration of the second epitaxial layer SD1b in the first source/drain patterns SD1 may be greater than a germanium concentration of the first epitaxial layer SD1a. For example, the germanium concentration of the first epitaxial layer SD1a may range from about 1 at% to about 15 at%, and the germanium concentration of the second epitaxial layer SD1b may range from about 20 at% to about 100 at%.

In one embodiment, when the second transistor TR2 is an NMOS transistor, a germanium concentration of the second epitaxial layer SD2b in the second source/drain patterns SD2 may be greater than a germanium concentration of the first epitaxial layer SD2a. For example, the germanium concentration of the first epitaxial layer SD2a may range from about 0 at% to about 15 at%, and the germanium concentration of the second epitaxial layer SD2b may range from about 20 at% to about 100 at%.

The first source/drain patterns SD1 may contain a semiconductor element (e.g., SiGe) having a lattice constant greater than a lattice constant of the semiconductor element of the substrate 100. Therefore, the pair of first source/drain patterns SD1 may provide compressive stress to the channel pattern CH therebetween. The second source/drain patterns SD2 may contain the same semiconductor element (e.g., Si) as that of the substrate 100. As an example, the second source/drain patterns SD2 may contain monocrystalline silicon.

In one embodiment, the second source/drain patterns SD2 may be provided with the same semiconductor element, for example, only Si without germanium, as that of the substrate 100. The first source/drain patterns SD1 may contain SiGe, and in this case, the first source/drain patterns SD1 may provide compressive stress to the channel pattern CH therebetween.

A pair of gate spacers GS may be provided on the channel pattern CH. The gate spacers GS may extend in the third direction DR3. The pair of gate spacers GS may be spaced apart from each other. The gate spacers GS may contain at least one of SiCN, SiCON, and SiN. As another embodiment, the gate spacers GS may include a multi-layer made of at least two of SiCN, SiCON, and SiN.

A gate capping pattern 140 may be disposed on the gate electrode GE. The gate capping pattern 140 may be provided between the pair of gate spacers GS. The gate capping pattern 140 may fill a space between the pair of gate spacers GS. The gate capping pattern 140 may be disposed on the channel pattern CH. The gate capping pattern 140 may contain at least one of SiON, SiCN, SiCON, and SiN.

A first interlayer insulating layer 130 may be provided on the substrate 100. The first interlayer insulating layer 130 may cover the first and second source/drain patterns SD1 and SD2. In one embodiment, an upper surface of the first interlayer insulating layer 130 may be substantially coplanar with an upper surface of the gate capping pattern 140 and upper surfaces of the gate spacers GS.

A second interlayer insulating layer 150 covering the gate capping pattern 140 may be provided on the first interlayer insulating layer 130. The second interlayer insulating layer 150 may cover the gate spacers GS and the first interlayer insulating layer 130. In one embodiment, the first and second interlayer insulating layers 130 and 150 may contain silicon oxide.

At least one contact CT for electrical connection with other components may be connected to at least one of the first and second source/drain patterns SD1 and SD2 of the first and second transistors TR1 and TR2. The contact CT may extend in the vertical direction, that is, in the third direction DR3, and may be connected to at least one of the gate electrode GE, and the first and second source/drain patterns SD1 and SD2. In the drawings, as a non-limiting example, the contacts CT are connected to one of the first source/drain patterns SD1 of the first transistor TR1 and one of the second source/drain patterns SD2 of the second transistor TR2.

The contacts CT may be made of a single conductive material, but are not limited thereto, and may contain a plurality of conductive materials. The conductive material may contain a metal and/or a metal nitride. The metal may be selected from Ti, W, Ru, Nb, Mo, Hf, Ni, Co, Pt, Yb, Tb, Dy, Er, and Pd. The metal nitride may be selected from TiN and TaN.

In one embodiment, an ohmic contact layer OCT may be provided between the contacts CT and the first and second source/drain patterns SD1 and SD2. The ohmic contact layer OCT may contain a metal silicide.

Hereinafter, a structure of the semiconductor device according to one embodiment of the present invention will be described in detail with reference to FIG. 3.

FIG. 3 is an enlarged cross-sectional view of portion P1 of FIG. 2A.

Referring to FIG. 3, the metal doped layer 103 may be provided on the active pattern AP of the substrate 100.

In one embodiment, the metal doped layer 103 may be a layer epitaxially grown layer from an upper surface of the substrate 100. For example, the metal doped layer 103 may be epitaxially grown from an upper surface of the active pattern AP and may be a monocrystalline layer. The metal doped layer 103 may be integrally formed without a distinguishable boundary with the active pattern AP. However, the metal doped layer 103 may differ from the active pattern AP in which a metal impurity is not doped in that the metal doped layer 103 contains a metal as an impurity.

The metal doped layer 103 contains a metal as an impurity therein. The metal in the metal doped layer 103 may be selected from those having oxygen reactivity higher than that of an element constituting the substrate 100. When the substrate 100 contains silicon, the metal may have oxygen reactivity higher than that of silicon That is, the metal may be more easily oxidized than silicon. In one embodiment, the metal may contain aluminum and/or nickel. In one embodiment, the metal may be aluminum.

A metal concentration in the metal doped layer 103 may vary, and may range, for example, from 1 × 10¹⁹ /cm³ to 5 × 10²¹ /cm³.

The barrier layer BL may be provided on the perimeter of each of the first source/drain patterns SD1 and the second source/drain patterns SD2. The barrier layer BL may surround a lower portion and side portions of each of the first source/drain patterns SD1 and the second source/drain patterns SD2.

The barrier layer BL may block leakage current between the first and/or second source/drain patterns SD1 and SD2 and prevent impurities in the first and/or second source/drain patterns SD1 and SD2 from diffusing into the channel patterns CH.

The barrier layer BL may include the first barrier layer BLa provided on the metal doped layer 103 and the second barrier layer BLb provided on side surfaces of the channel pattern CH and side surfaces of the gate insulating layer GI. The first barrier layer BLa is provided between the metal doped layer 103 and the first and second source/drain patterns SD1 and SD2, and the second barrier layer BLb is provided between the channel pattern CH and the first and second source/drain patterns SD1 and SD2 and between the gate electrode GE and the first and second source/drain patterns SD1 and SD2.

The first barrier layer BLa may fill at least a portion of a depressed portion of an upper surface of the metal doped layer 103. The first barrier layer BLa may be provided in a concave shape along an upper surface of the depressed portion of the metal doped layer 103. In a plan view, an uppermost surface of the first barrier layer BLa may be positioned at substantially the same level as the upper surface of the metal doped layer 103.

The first barrier layer BLa may be epitaxially grown from the metal doped layer 103 and may have substantially the same crystalline structure as that of the metal doped layer 103. The first barrier layer BLa contains a metal oxide in its crystal structure. A metal in the first barrier layer BLa may be the same as the metal contained in the metal doped layer 103. That is, the metal in the first barrier layer BLa may include one having oxygen reactivity higher than that of the element constituting the substrate 100. For example, the metal in the first barrier layer BLa may contain aluminum and/or nickel. In one embodiment, the metal may be aluminum.

The first barrier layer BLa prevents leakage current between the adjacent first and second source/drain patterns SD1 and SD2 by surrounding the lower portions of the first and second source/drain patterns SD1 and SD2. In particular, the first barrier layer BLa may block a leakage path that may be generated in a lower portion of the channel pattern CH disposed between the first and second source/drain patterns SD1 and SD2 that are adjacent to each other. A bandgap of the metal oxide constituting the first barrier layer BLa is greater than a bandgap of the substrate 100. For example, the substrate 100 may be silicon and the metal oxide may aluminum oxide, which has a much greater bandgap than that of silicon. In a case of a PMOS transistor and/or an NMOS transistor, since a band offset at an interface with the metal oxide is large, it is very difficult for carriers such as holes and electrons to overcome the band offset. Accordingly, the leakage current between the first and second source/drain patterns SD1 and SD2 that are adjacent to each other is prevented.

The first barrier layer BLa may have a first thickness W1. The first thickness W1 may be a thickness sufficient to prevent the leakage current between the first and second source/drain patterns SD1 and SD2. For example, the first thickness W1 may range from about 10 angstroms to about 100 angstroms, or from about 10 angstroms to about 50 angstroms.

The second barrier layer BLb may be provided between the channel pattern CH and the first and second source/drain patterns SD1 and SD2, and between the gate insulating layer GI and the first and second source/drain patterns SD1 and SD2. The second barrier layer BLb may be conformally provided along the side surfaces of the channel patterns CH and the side surfaces of the gate insulating layer GI.

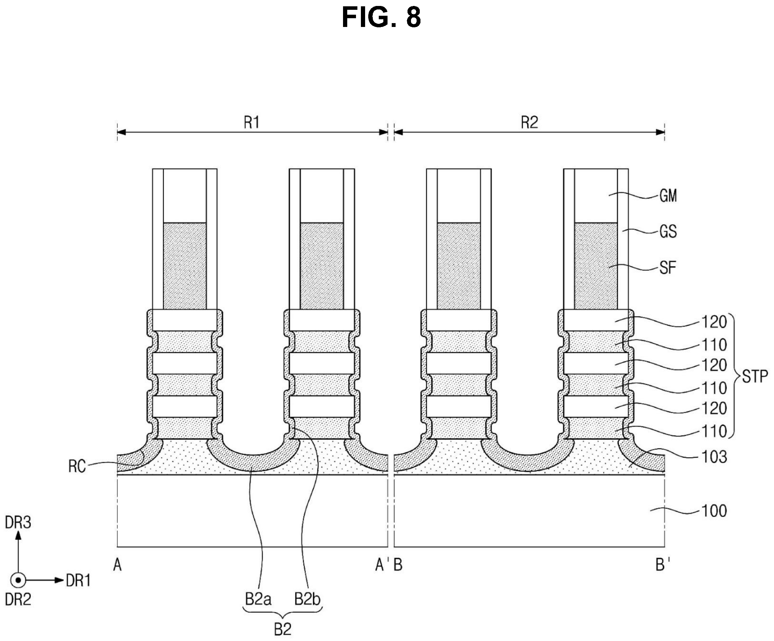

The second barrier layer BLb may be epitaxially grown from first semiconductor layers 110 (see FIG. 8, which will later be included in the channel patterns CH) and second semiconductor layers 120 (see FIG. 8) that will be described below. In one embodiment, the second barrier layer BLb may have substantially the same crystal structure as the channel pattern CH. The second barrier layer BLb contains a metal oxide in its crystal structure. The metal in the second barrier layer BLb may be the same as the metal in the first barrier layer BLa. For example, the metal in the second barrier layer BLb may contain aluminum and/or nickel. In one embodiment, the metal may be aluminum.

The second barrier layer BLb blocks diffusion of impurities in the first and second source/drain patterns SD1 and SD2 from the first and second source/drain patterns SD1 and SD2 toward the channel pattern CH by surrounding the side portions of the first and second source/drain patterns SD1 and SD2. That is, the second barrier layer BLb functions as a barrier layer blocking the impurities from the first and second source/drain patterns SD1 and SD2. For example, the impurities may contain an N-type impurity such as phosphorus or a P-type impurity such as arsenic.

The second barrier layer BLb may have a second thickness W2 smaller than the thickness of the first barrier layer BLa. The second barrier layer BLb may have a thickness that may not prevent movement of charges between the channel patterns CH and the first and second source/drain patterns SD1 and SD2 when a voltage is applied to the gate electrode GE of the first and/or second transistors TR1 and TR2. That is, the second thickness W2 may have a value such that the charges can move between the channel patterns CH and the first and second source/drain patterns SD1 and SD2 through tunneling. In addition, the second thickness W2 may have a value sufficient to block diffusion of impurities from the first and second source/drain patterns SD1 and SD2 to the channel patterns CH. The second thickness W2 according to one embodiment satisfying the above conditions may range from about 3 angstroms to about 15 angstroms, or from about 5 angstroms to about 10 angstroms. When the second thickness W2 is smaller than the above value, the impurity diffusion prevention effect is not sufficient, and when it is larger than the above value, the charge tunneling effect cannot be sufficiently expected.

Metal concentrations in the first barrier layer BLa and the second barrier layer BLb have values within a range that allows epitaxial growth during the manufacturing process of the first and second barrier layers BLa and BLb. For example, the metal concentrations in the metal oxides in the first barrier layer BLa and the second barrier layer BLb may each range from about 1×10¹⁹ /cm³ to about 5×10²¹ /cm³. When the metal concentrations in the first barrier layer BLa and the second barrier layer BLb are less than the above value, the leakage current blocking effect in the first barrier layer BLa is not sufficient, and the impurity blocking effect in the second barrier layer BLb may not be significant. When the metal concentrations in the first barrier layer BLa and the second barrier layer BLb are greater than the above value, epitaxial growth of not only the first and second barrier layers BLa and BLb but also the first and second source/drain patterns SD1 and SD2 in subsequent processes may be difficult due to the high metal oxide content.

Concentrations of the metal oxides in the first barrier layer BLa and the second barrier layer BLb are not limited thereto. For example, the first barrier layer BLa and the second barrier layer BLb may have different concentrations with respect to the metal constituting the metal oxide. For example, the metal concentration in the second barrier layer BLb may be about 70% or less, about 50% or less, or about 30% or less of the metal concentration in the first barrier layer BLa. In one embodiment, the metal concentration in the barrier layer BL may be the same as or different from the metal concentration in the metal doped layer 103. For example, the metal concentration in the second barrier layer BLb may differ from the metal concentration in the metal doped layer 103.

In one embodiment, the first barrier layer BLa and the second barrier layer BLb may contain the same material. For example, the first barrier layer BLa and the second barrier layer BLb may contain the same metal oxide and have the same metal concentration in the metal oxide.

The first barrier layer BLa and the second barrier layer BLb may be integrally formed as an undivided structure.

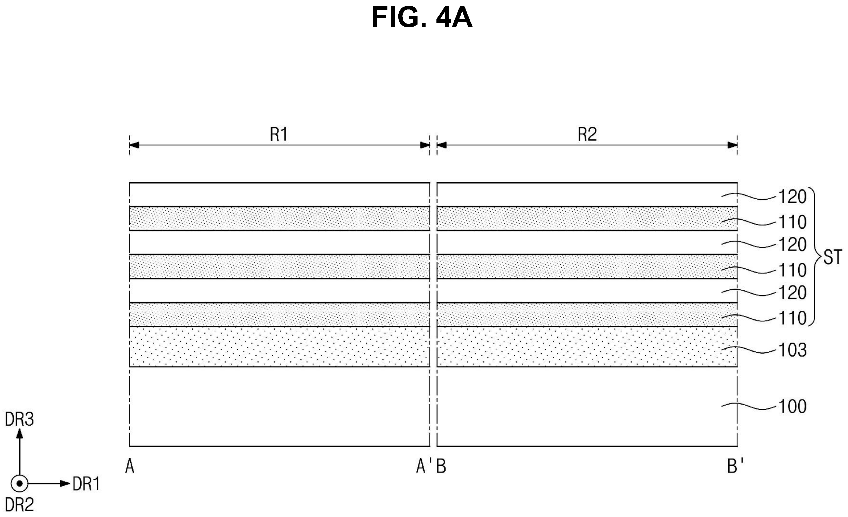

FIGS. 4A to 15B sequentially show a manufacturing method of the semiconductor device according to one embodiment of the present invention, wherein FIGS. 4A, 5A, 6 to 10, 11A, 12A, 13A, 14A, and 15 are cross-sectional views taken along line A-A' and line B-B' of FIG. 1, and FIGS. 4B, 5B, 11B, 12B, 13B, and 14B are cross-sectional views taken along line C-C' of FIG. 1.

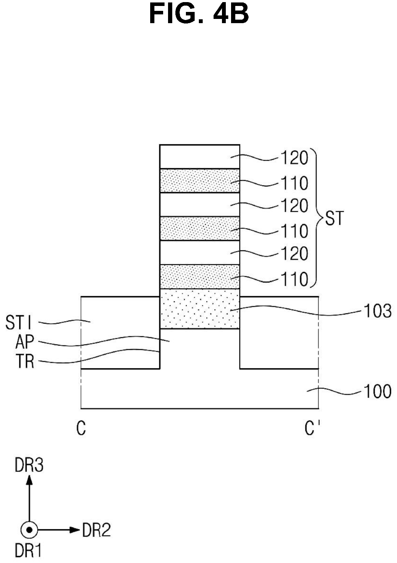

Referring to FIGS. 4A and 4B, a metal doped layer 103 and a preliminary stacked pattern ST may be sequentially formed on a first region R1 and a second region R2 of a substrate 100.

The metal doped layer 103 is for forming a barrier layer BL, particularly a first barrier layer BLa, to be described below, and may be formed on the substrate 100.

The metal doped layer 103 may contain a metal impurity and may be formed by an epitaxial growth process. For example, the metal doped layer 103 may be formed by a molecular beam epitaxy (MBE) process, a metalorganic chemical vapor deposition (MOCVD) process, and/or other suitable epitaxial growth processes.

In one embodiment, a metal concentration in the metal doped layer 103 may range from 1×10¹⁹/cm³ to 5×10²¹/cm³.

Each preliminary stacked pattern ST may be formed on the metal doped layer 103 to facilitate formation of channel patterns to be described below.

The preliminary stacked pattern ST may include first semiconductor layers 110 and second semiconductor layers 120 that are alternately stacked with each other. The first semiconductor layers 110 and the second semiconductor layers 120 may have different compositions from each other. The first semiconductor layers 110 and the second semiconductor layers 120 may provide different etch selectivities and/or different oxidation rates.

In one embodiment, the preliminary stacked pattern ST may include three layers of the first semiconductor layers 110 and three layers of the second semiconductor layers 120. However, the number of semiconductor layers included in the preliminary stacked pattern ST is not limited thereto. In other embodiments, more or fewer semiconductor layers may be included in the preliminary stacked pattern ST. For example, in some embodiments, the number of the first and second semiconductor layers 110 and 120 in the preliminary stacked pattern ST may range from 1 to 10.

The first semiconductor layers 110 may contain one of silicon (Si), germanium (Ge), and silicon-germanium (SiGe). The second semiconductor layers 120 may contain other materials excluding materials forming the first semiconductor layers 110, for example, compound semiconductors such as Si, Ge, SiC, GeAs, GaP, InP, InAs, and/or InSb, alloy semiconductors such as SiGe, GaAsP, AlInAs, AlGaAs, InGaAs, GaInP, and/or GaInAsP, or a combination thereof. In one embodiment, the first semiconductor layers 110 may contain silicon-germanium (SiGe), and the second semiconductor layers 120 may contain silicon (Si).

The first and second semiconductor layers 110 and 120 may be formed by the MBE process, the MOCVD process, and/or other suitable epitaxial growth processes. Some of the first and second semiconductor layers 110 and 120 may be removed in subsequent processes and may serve to define vertical distances between the adjacent channel patterns for the semiconductor device to be finally formed. In one embodiment, a thickness of each of the first and second semiconductor layers 110 and 120 may be variously modified depending on embodiments.

A mask pattern may be formed on the preliminary stacked pattern ST of the substrate 100. By performing a patterning process of the preliminary stacked pattern ST and the substrate 100 using the mask pattern as an etch mask, a trench TR defining the metal doped layer 103 and an active pattern AP may be formed. The trench TR may include multiple trenches TR may be formed on both sides of the metal doped layer 103 and the active pattern AP.

A shallow trench isolation pattern STI pattern may fill the trench TR. Specifically, an insulating layer covering the active pattern AP, the metal doped layer 103, and the preliminary stacked pattern ST may be formed on the entire surface of the substrate 100. The insulating layer may be recessed until the preliminary stacked pattern ST is exposed to form the shallow trench isolation pattern STI. The shallow trench isolation pattern STI may be formed by a high-density plasma chemical vapor deposition (HDP-CVD) process, a flowable chemical vapor deposition (FCVD) process, or other suitable deposition processes.

The shallow trench isolation pattern STI may contain silicon oxide, silicon nitride, silicon oxynitride, fluorine-doped silicate glass (FSG), low-k dielectric, or a combination thereof. In one embodiment, the shallow trench isolation pattern STI may contain silicon oxide. The preliminary stacked pattern ST may be exposed above the shallow trench isolation pattern STI. In other words, the preliminary stacked pattern ST may vertically protrude above the shallow trench isolation pattern STI.

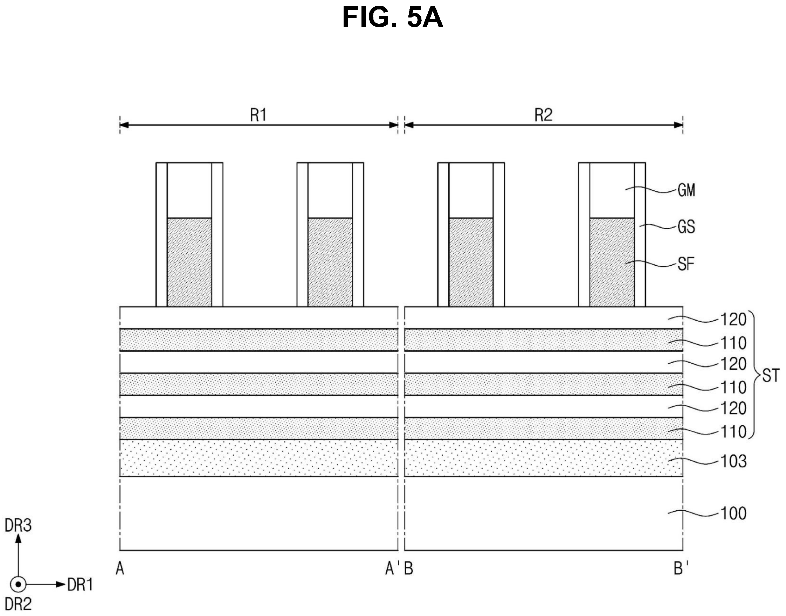

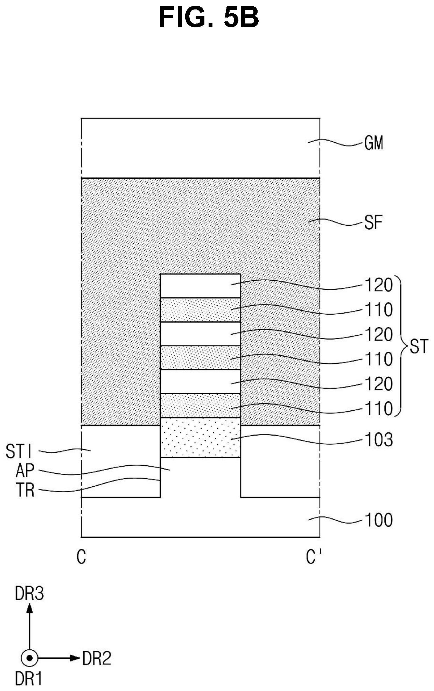

Referring to FIGS. 5A and 5B, a sacrificial pattern SF may be formed on the preliminary stacked pattern ST.

The sacrificial pattern SF may contain various materials, for example, polysilicon. The sacrificial pattern SF may be replaced with a gate electrode GE of the semiconductor device in a subsequent process, and accordingly, a width of the sacrificial pattern SF may be substantially the same as a width of the gate electrode GE of the semiconductor device to be replaced later.

Forming the sacrificial pattern SF may include forming a sacrificial film on the entire surface of the substrate 100, forming a gate mask GM on the sacrificial film, and patterning the sacrificial film using the gate mask GM as an etch mask.

The sacrificial film may be deposited using chemical vapor deposition (CVD) including low pressure chemical deposition (LPCVD) and plasma enhanced chemical vapor deposition (PECVD), physical vapor deposition (PVD), atomic layer deposition (ALD), or other suitable processes. A portion of the sacrificial film may be removed using plasma dry etching and/or wet etching. In some embodiments, when the sacrificial film contains polysilicon, the wet etching may be performed to selectively remove a portion of the sacrificial film, and various etchants such as tetramethylammonium hydroxide (TMAH) solution may be used.

A pair of gate spacers GS may be formed on both sidewalls of each sacrificial pattern SF. Forming the gate spacers GS may include conformally forming a gate spacer film on an upper surface of the substrate 100 and anisotropically etching the gate spacer film. The gate spacer GS may contain materials such as SiOₓ, SiCN, SiCON, SiN, SiON, and the like. As another example, the gate spacer GS may be a multi-layer containing at least two of SiCN, SiCON, and SiN. The gate spacer GS film may be deposited using CVD including LPCVD and PECVD, PVD, ALD, or other suitable processes.

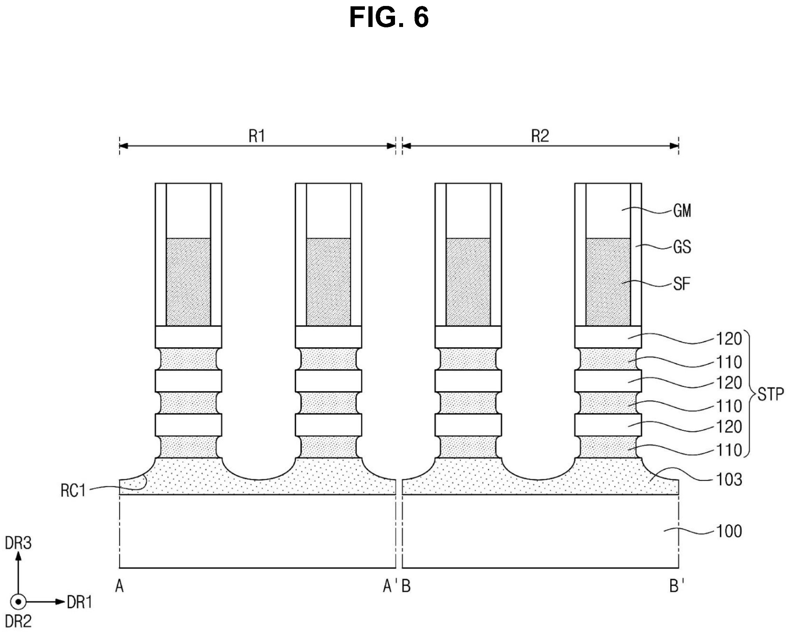

Referring to FIG. 6, first recesses RC1 may be formed in the metal doped layer 103 and the preliminary stacked pattern ST. The first recesses RC1 may be formed corresponding to regions in which first source/drain patterns SD1 are to be formed in the first region R1 and may be formed corresponding to regions in which second source/drain patterns SD2 are to be formed in the second region R2. Specifically, the first recesses RC1 may be formed by sequentially etching upper portions of the preliminary stacked pattern ST and the metal doped layer 103 using the gate mask GM and the gate spacers GS as etch masks. The first recess RC1 may be formed in a depressed shape from an upper surface of the metal doped layer 103, and may not pass through until reaching the upper surface of the substrate 100, that is, an upper surface of the active pattern AP.

Stacked patterns STP that are spaced apart from each other and stacked may be formed by the first recesses RC1. The first and second semiconductor layers 110 and 120 that are vertically overlapped and stacked between the first recesses RC1 may form one stacked pattern STP.

A portion of the preliminary stacked pattern ST may be removed together with or separately from the gate spacers GS and the first and second semiconductor layers 110 and 120 by suitable dry etching and/or wet etching processes. The etching process may be anisotropically performed using the sacrificial pattern SF and the gate spacers GS provided on an upper portion of the stacked pattern STP as masks.

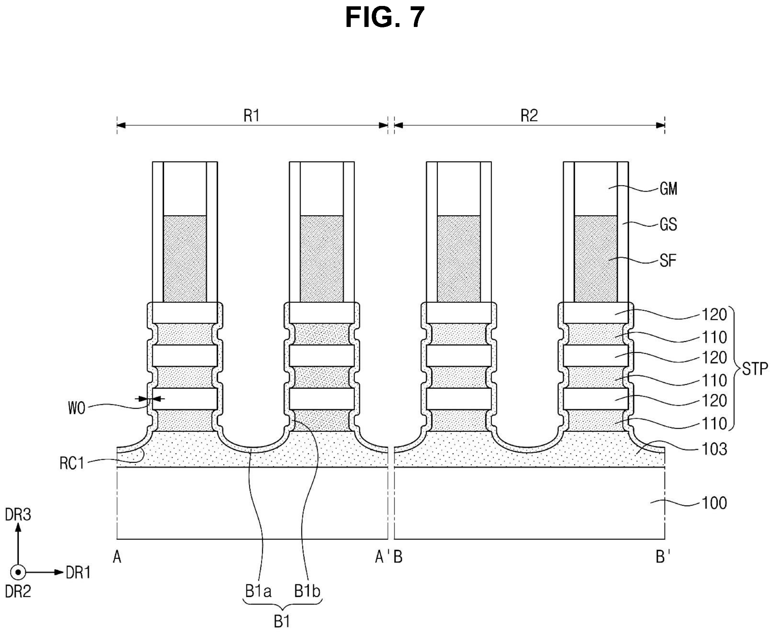

Referring to FIG. 7, a first preliminary barrier layer B1 may be formed in the first recess RC1. The first preliminary barrier layer B1 may be formed in the first recess RC1 by an epitaxial growth method. For example, the first preliminary barrier layer B1 may be formed by plasma enhanced atomic layer deposition (PEALD), but a formation method of the first preliminary barrier layer B1 is not limited thereto.

The first preliminary barrier layer B1 may be conformally formed along an inner surface of the first recess RC1. Here, a depressed portion of the upper surface of the substrate 100 corresponding to the first recess RC1 after the first preliminary barrier layer B1 is formed is referred to as "recess RC" for convenience.

The first preliminary barrier layer B1 may include a first portion B1a corresponding to its lower portion and a second portion B1b corresponding to its side portion. That is, the first portion B1a may be referred to as a lower first preliminary barrier layer B1, and the second portion B1b may be referred to as a side first preliminary barrier layer B1. The first portion B1a and the second portion B1b may be integrally formed as an undivided structure.

In the first preliminary barrier layer B1, the first portion B1a may be formed on a lower surface of the first recess RC1. The first portion B1a may fill at least a portion of the depressed portion of the upper surface of the metal doped layer 103. The first portion B1a may be provided in a concave shape along an upper surface of a depressed portion of the metal doped layer 103. The first portion B1a may be epitaxially grown from the metal doped layer 103 and may have substantially the same crystalline structure as that of the metal doped layer 103. The second portion B1b may be formed on side surfaces of the first recess RC1. In other words, the second portion B1b may be formed on side surfaces of the first and second semiconductor layers 110 and 120. The second portion B1b may be epitaxially grown from the first and second semiconductor layers 110 and 120 and may have substantially the same crystal structure as those of the first and second semiconductor layers 110 and 120. The first portion B1a and the second portion B1b may be epitaxially grown simultaneously and may be formed with a substantially identical thickness WO.

The first preliminary barrier layer B1 may be formed to contain a metal. The metal in the first preliminary barrier layer B1 may be the same as the metal contained in the metal doped layer 103. That is, the metal in the first preliminary barrier layer B1 may contain one having oxygen reactivity higher than that of the element constituting the substrate 100. For example, the metal in the first preliminary barrier layer B1 may contain aluminum and/or nickel. In one embodiment, the metal may be aluminum. In one embodiment, the first preliminary barrier layer B1 may contain Si doped with aluminum, or SiGe doped with aluminum.

In one embodiment, a metal concentration of the first preliminary barrier layer B1 may range from about 1×10¹⁹/cm³ to about 5×10²¹/cm³. When the metal concentration in the first preliminary barrier layer B1 is greater than the above value, epitaxial growth of the first preliminary barrier layer B1 and epitaxial growth of the first and second source/drain patterns SD1 and SD2 in subsequent processes may be difficult due to the high metal content. When the metal concentration in the first preliminary barrier layer B1 is less than the above value, it is difficult to achieve a leakage current blocking effect or an impurity diffusion prevention effect in the final semiconductor device after the process is completed.

In one embodiment, the metal concentration of the first preliminary barrier layer B1 may be substantially the same as a metal concentration of the metal doped layer 103. However, the metal concentration of the first preliminary barrier layer B1 is not limited thereto and may have a different concentration from the metal concentration of the metal doped layer 103. For example, the metal concentration of the first preliminary barrier layer B1 may be about 70% or less, about 50% or less, or about 30% or less of the metal concentration of the metal doped layer 103.

A thickness of the first preliminary barrier layer B1 may be set considering a thickness of a final barrier layer BL after the process is completed. For example, the thickness of the first preliminary barrier layer B1 may range from about 5 angstroms to about 50 angstroms, or from about 10 angstroms to about 30 angstroms.

Referring to FIG. 8, portions of the first preliminary barrier layer B1 and the metal doped layer 103 are oxidized to form a second preliminary barrier layer B2. The second preliminary barrier layer B2 may be formed by oxidizing the first preliminary barrier layer B1. In one embodiment, the oxidation may be performed in a dry process and may be performed by thermal oxidation. In one embodiment, the second preliminary barrier layer B2 may be formed in-situ by supplying oxygen in a process chamber for forming the first and second source/drain patterns SD1 and SD2, before forming the first and second source/drain patterns SD1 and SD2.

Since the metal in the first preliminary barrier layer B1 has oxygen reactivity higher than the elements constituting the substrate 100 and elements constituting the first and second semiconductor layers 110 and 120, it may be easily oxidized. For example, aluminum in the first preliminary barrier layer B1 is more quickly and easily oxidized than Si and/or SiGe constituting the substrate 100 and/or the first and second semiconductor layers 110, 120. In this case, the first preliminary barrier layer B1 may be a Si layer containing aluminum oxide (AlₓO_{y}), or a SiGe layer containing aluminum oxide.

The second preliminary barrier layer B2 may include a first portion B2a corresponding to its lower portion and a second portion B2b corresponding to its side portion. That is, the first portion B2a may be referred to as a lower second preliminary barrier layer B2, and the second portion B2b may be referred to as a side second preliminary barrier layer B2. The first portion B2a and the second portion B2b may be integrally formed as an undivided structure.

The first portion B2a of the second preliminary barrier layer B2 is formed by oxidation of the first portion B1a of the first preliminary barrier layer B1. The second portion B2b of the second preliminary barrier layer B2 is formed by oxidation of the first portion B1b of the first preliminary barrier layer B1 and a portion of the metal doped layer 103. Accordingly, the second portion B2b of the second preliminary barrier layer B2 may be thicker than the first portion B2a of the second preliminary barrier layer B2.

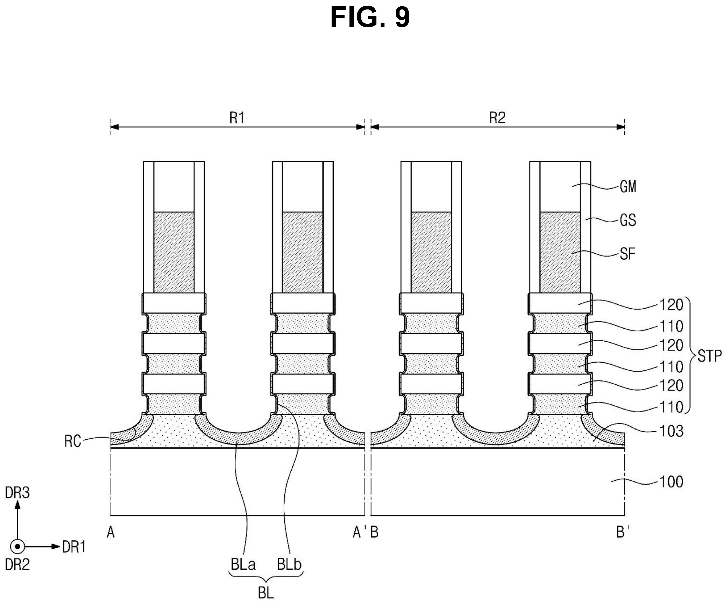

Referring to FIG. 9, an etch-back process is performed on the second preliminary barrier layer B2 to form the barrier layer BL. In one embodiment, the etch-back process may be performed in a device that removes and/or cleans silicon oxide or metal oxide.

The barrier layer BL may include a first barrier layer BLa corresponding to its lower portion and a second barrier layer BLb corresponding to its side portion. The first barrier layer BLa and the second barrier layer BLb may be formed simultaneously, and accordingly, the first barrier layer BLa and the second barrier layer BLb may be integrally formed as an undivided structure. In one embodiment, a thickness of the first barrier layer BLa may be smaller than a thickness of the first portion B2a of the second preliminary barrier layer B2, and a thickness of the second barrier layer BLb may be smaller than a thickness of the second portion B2b of the second preliminary barrier layer B2.

In one embodiment, the etch-back process may be performed until the thickness of the barrier layer BL falls within a range of a predetermined thickness. For example, the etch-back process may be performed until the thickness of the first barrier layer BLa falls within a range of from about 10 angstroms to about 100 angstroms, or from about 10 angstroms to about 50 angstroms, and may be performed until the thickness of the second barrier layer BLb falls within a range of from about 3 angstroms to about 15 angstroms, or from about 5 angstroms to about 10 angstroms.

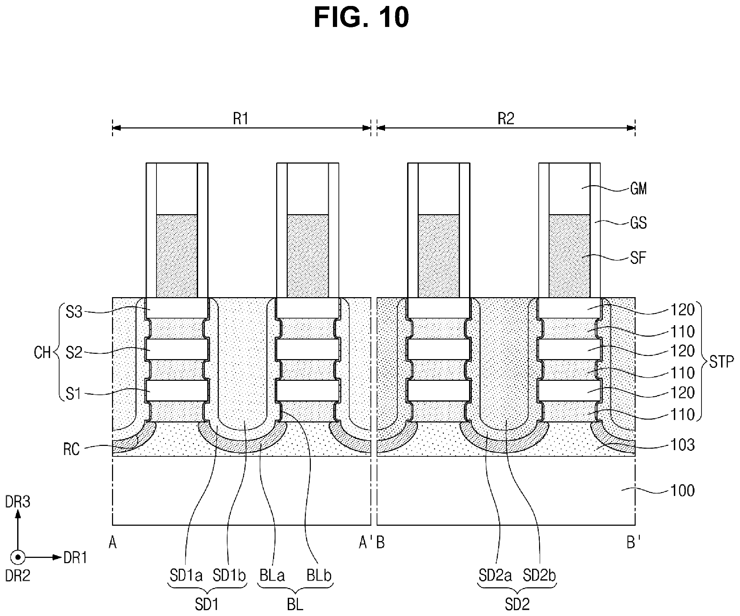

Referring to FIG. 10, the first and second source/drain patterns SD1 and SD2 may be formed in the recesses RC. The first and second source/drain patterns SD1 and SD2 may be formed of epitaxially grown semiconductor layers. The first and second source/drain patterns SD1 and SD2 may be grown using the barrier layer BL exposed by the recesses RC as a seed. In one embodiment, a selective epitaxial growth (SEG) process may include a CVD process or a molecular beam epitaxy (MBE) process.

The first source/drain patterns SD1 and the second source/drain patterns SD2 may each be formed on both sides of the stacked pattern STP.

In one embodiment, the first source/drain patterns SD1 and the second source/drain patterns SD2 may contain different types of impurities and may be formed to include impurities of different concentrations.

To form the first source/drain patterns SD1, a first SEG process using inner sidewalls of the recesses RC as seed layers may be performed to form first epitaxial layers SD1a. The first epitaxial layer SD1a may be grown using the first barrier layer BLa and the second barrier layer BLb that are exposed by the recesses RC as seeds. For example, the first SEG process may include the CVD process or the MBE process.

The first epitaxial layer SD1a may contain a semiconductor element (e.g., SiGe) having a lattice constant greater than a lattice constant of the semiconductor element of the substrate 100. The first epitaxial layer SD1a may contain a relatively low concentration of germanium. In another embodiment of the present invention, the first epitaxial layer SD1a may contain only silicon (Si) excluding germanium. A germanium concentration of the first epitaxial layer SD1a may range from 0 at% to 10 at%.

A second SEG process may be performed on the first epitaxial layer SD1a to form a second epitaxial layer SD1b. The second epitaxial layers SD1b may contain a relatively high concentration of germanium. For example, a germanium concentration of the second epitaxial layers SD1b may range from 30 at% to 70 at%.

During formation of the first epitaxial layer SD1a and the second epitaxial layer SD1b, an impurity (e.g., P-type impurity such as boron, gallium, or indium) may be in-situ injected into the first source/drain patterns SD1. As another example, the impurity may be injected into the first source/drain patterns SD1 after the first source/drain patterns SD1 are formed.

By forming the first source/drain patterns SD1, a channel pattern CH may be formed between the two first source/drain patterns SD1. The channel pattern CH may include first to third semiconductor patterns S1, S2, and S3 that are sequentially stacked.

To form the second source/drain patterns SD2, the first SEG process using the inner sidewalls of the recesses RC as seed layers may be performed to form first epitaxial layers SD2a. The first epitaxial layers SD2a may be grown using the first and second barrier layers BLa and BLb that are exposed by the recesses RC as seeds. For example, the first SEG process may include the CVD process or the MBE process.

In one embodiment, the second source/drain pattern SD2 may contain the same semiconductor element (e.g., Si) as that of the substrate 100. However, the element contained in the second source/drain pattern SD2 is not limited thereto, and the first epitaxial layer SD2a may contain a semiconductor element (e.g., SiGe) having a lattice constant greater than the lattice constant of the semiconductor element of the substrate 100. The first epitaxial layer SD2a may contain a relatively low concentration of germanium. In another embodiment of the present invention, the first epitaxial layer SD2a may contain only silicon (Si) excluding germanium. A germanium concentration of the first epitaxial layer SD2a may range from 0 at% to 10 at%. The second SEG process may be performed on the first epitaxial layer SD2a to form a second epitaxial layer SD2b. The second epitaxial layers SD2b may contain a relatively high concentration of germanium. For example, a germanium concentration of the second epitaxial layers SD2b may range from 30 at% to 70 at%.

During formation of the first epitaxial layer SD2a and the second epitaxial layer SD2b, in-situ (e.g., N-type impurity such as phosphorus, arsenic, or antimony) may be in-situ injected into the second source/drain patterns SD2. As another example, the impurity may be injected into the second source/drain patterns SD2 after the second source/drain patterns SD2 are formed.

By forming the second source/drain patterns SD2, the channel pattern CH may be formed between the two second source/drain patterns SD2. The channel pattern CH may include the first to third semiconductor patterns S1, S2, and S3 that are sequentially stacked.

Although not shown, a source/drain capping film may be further provided on the first and second source/drain patterns SD1 and SD2.

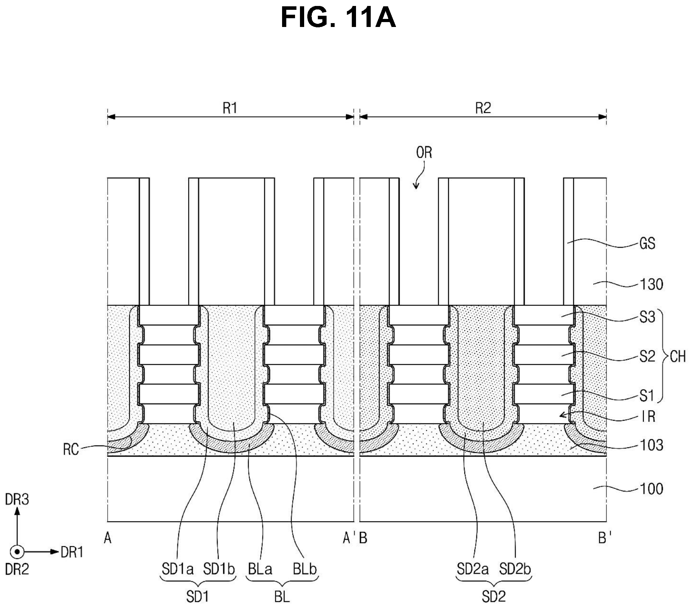

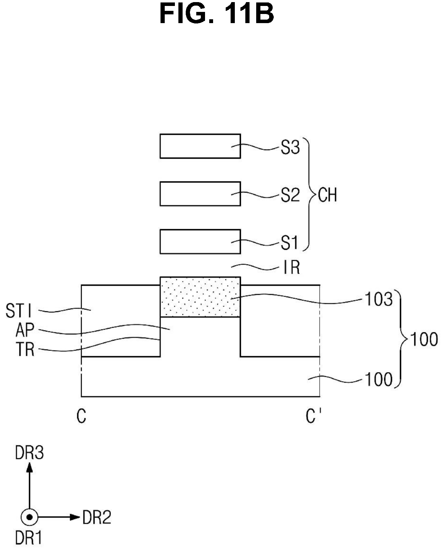

Referring to FIGS. 11A and 11B, a first interlayer insulating layer 130 may be formed on the second source/drain pattern SD2. Specifically, the first interlayer insulating layer 130 may cover the second source/drain pattern SD2. The first interlayer insulating layer 130 may contain silicon oxide. The first interlayer insulating layer 130 may be filled to a height corresponding to an upper surface of the gate spacer GS and a height corresponding to an upper surface of the gate mask GM.

Although not shown, a protective insulating pattern may be formed in the first interlayer insulating layer 130. Specifically, the first interlayer insulating layer 130 may be recessed, and the protective insulating pattern may be filled on the recessed first interlayer insulating layer 130.

Next, the gate mask GM and the sacrificial patterns SF may be selectively removed. By removing the gate mask GM and the sacrificial patterns SF, an outer region OR exposing uppermost surfaces of the channel patterns CH may be formed. The sacrificial patterns SF may be removed by a wet etching process. In the wet etching process, for example, an etchant that selectively etches polysilicon may be used.

Thereafter, the first semiconductor layers 110 exposed through the outer region OR may be selectively removed to form inner regions IR. The inner regions IR may be regions between the substrate 100 and the second semiconductor pattern S2 and between the adjacent first to third semiconductor patterns S1, S2, and S3 of the stacked pattern STP. Specifically, an etching process that selectively etches the first semiconductor layers 110 may be performed to remove only the first semiconductor layers 110 while leaving the second semiconductor layers 120 intact. The etching process may utilize the fact that the etching rate varies depending on the germanium concentration. In one embodiment, the first semiconductor layers 110 may be selectively etched using a wet etchant such as, but not limited to, ammonium hydroxide (NH₄OH), tetramethylammonium hydroxide (TMAH), ethylenediamine pyrocatechol (EDP), or potassium hydroxide (KOH) solution.

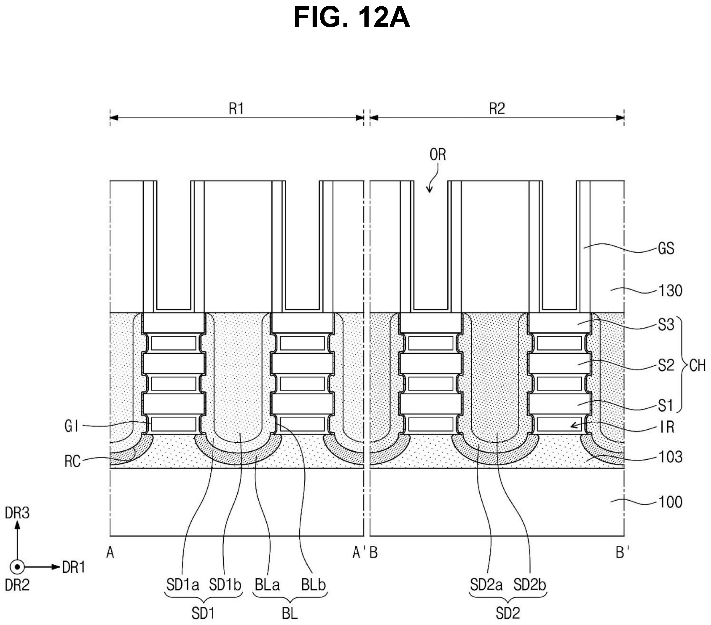

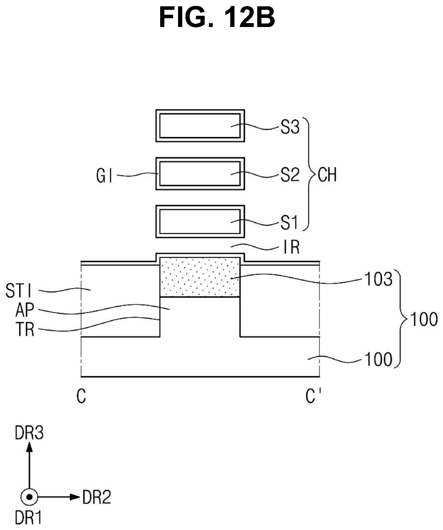

Referring to FIGS. 12A and 12B, a gate insulating layer GI may be formed in the exposed inner region IR and outer region OR above the metal doped layer 103. In one embodiment, the gate insulating layer GI may be conformally formed in the inner region IR and the outer region OR.

The gate insulating layer GI may include an interface layer and a high-k dielectric layer on the interface layer. In one embodiment, the high-k dielectric layer may be thicker than the interface layer. The interface layer may contain silicon oxide or silicon oxynitride. The high-k dielectric layer may contain a high-k material having a dielectric constant higher than that of silicon oxide. For example, the high-k material may contain at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanate, barium titanate, strontium titanate, lithium oxide, aluminum oxide, lead scandium tantalate, and lead zinc niobate.

The gate insulating layer GI may be formed by ALD, CVD, or other suitable methods.

Although not shown, inner spacers may be further formed before forming the gate insulating layer GI. The inner spacers may be formed by forming an insulating film covering the first and/or second source/drain patterns SD1 and SD2 and then performing an etching process. The inner spacers may contain at least one of SiO₂, SiN, SiC, SiOC, and AlOₓ.

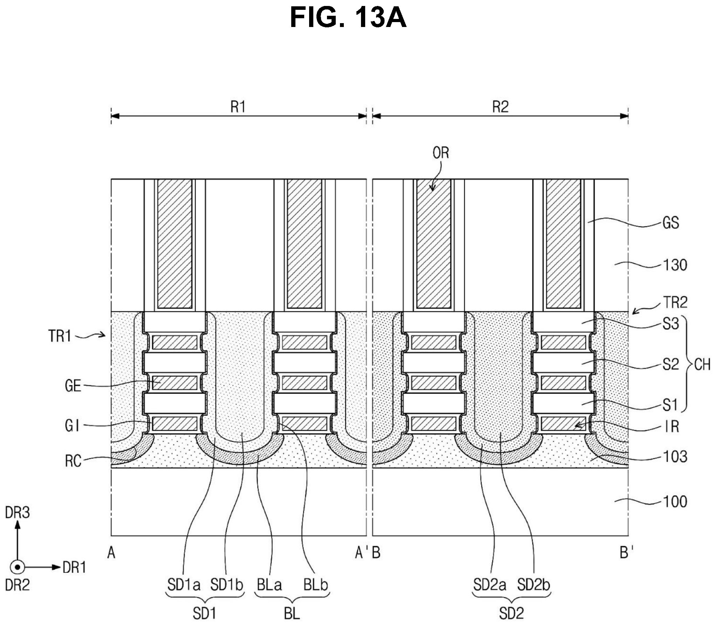

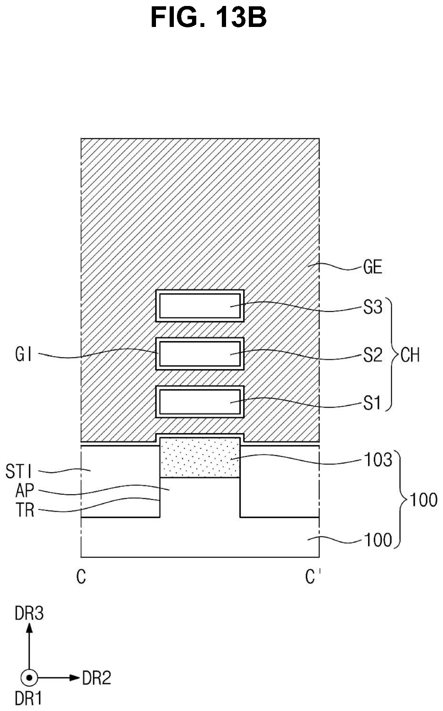

Referring to FIGS. 13A and 13B, a gate electrode GE may be formed on the gate insulating layer GI. The gate electrode GE may be formed to fill a portion of the outer region OR and the inner region IR. The gate electrode GE may include portions formed in each of the inner regions IR and a portion formed in the outer region OR. The gate electrode GE may be formed between the adjacent first source/drain patterns SD1 and between the adjacent second source/drain patterns SD2.

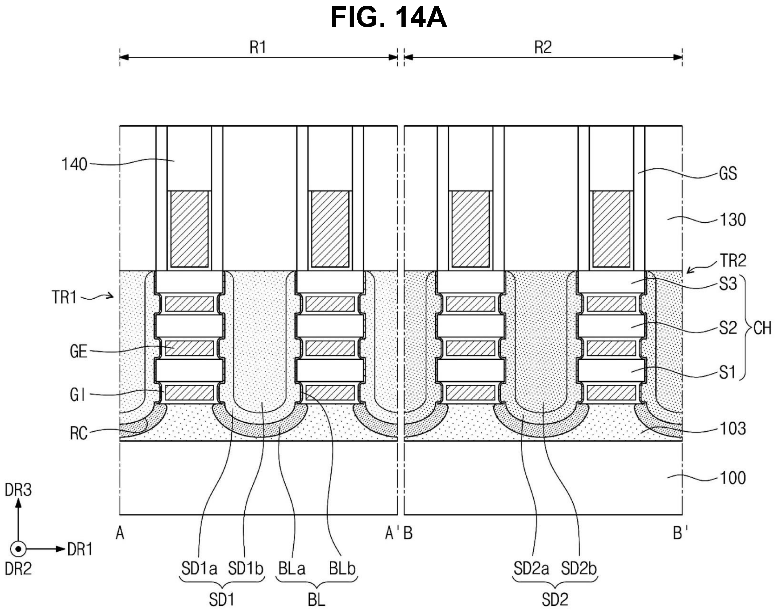

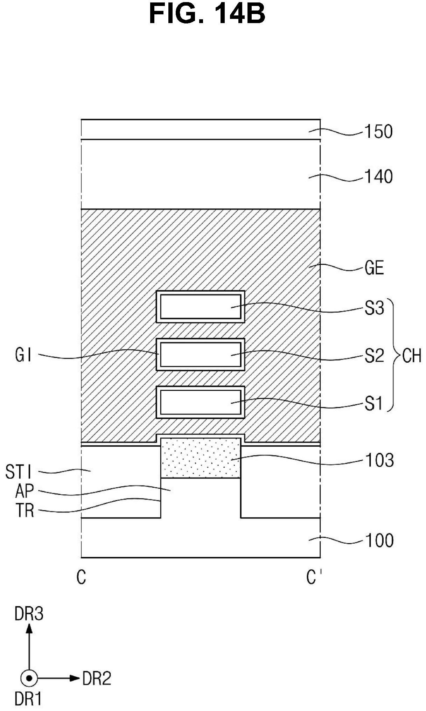

Referring to FIGS. 14A and 14B, a gate capping pattern 140 may be formed on the gate. The gate capping pattern 140 may fill a space between the pair of gate spacers GS. An upper surface of the gate capping pattern 140 may be substantially coplanar with the upper surfaces of the gate spacers GS and an upper surface of the protective insulating pattern. The gate capping pattern 140 may contain SiN.

A second interlayer insulating layer 150 may be formed on the gate capping pattern 140. The second interlayer insulating layer 150 may cover the first interlayer insulating layer 130 and the gate spacers GS. The second interlayer insulating layer 150 may contain silicon oxide.

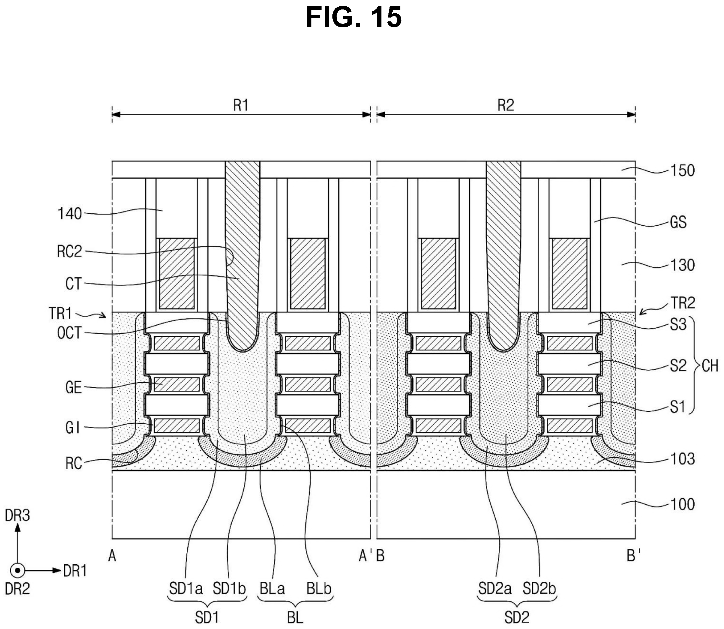

Referring to FIG. 15, at least one contact CT for electrically connecting the gate electrodes GE and the first and/or second source/drain patterns SD1 and SD2 to other components may be formed. FIG. 15 shows, as an example, the contacts CT vertically connected to the first and second source/drain patterns SD1 and SD2.

First, second recesses RC2 may be formed in the first and second source/drain patterns SD1 and SD2 (see FIG. 2A). The second recesses RC2 may vertically pass through the first and second source/drain patterns SD1 and SD2 and may have a shape depressed vertically downward from upper surfaces of the first and second source/drain patterns SD1 and SD2.

Specifically, the second recesses RC2 may vertically pass through the second interlayer insulating layer 150, the first interlayer insulating layer 130, and the first and second source/drain patterns SD1 and SD2 and may have a shape depressed downward from the upper surfaces of the first and second source/drain patterns SD1 and SD2.

Next, an ohmic contact layer OCT may be selectively formed on the first and second source/drain patterns SD1 and SD2 exposed in the second recesses RC2. The ohmic contact layer OCT may contain a metal silicide. The ohmic contact layer OCT may be selectively formed only on the second source/drain pattern SD2 by performing annealing after forming a metal film and removing the remaining metal.

The contacts CT are formed by forming a conductive material in the second recesses RC2. The contacts CT may be made of a single conductive material, but are not limited thereto, and may contain a plurality of conductive materials.

A method of forming the conductive material in the second recess RC2 is not particularly limited and various methods may be used. For example, an operation of forming the conductive material in the second recess RC2 may be performed by the CVD.

According to embodiments of the present disclosure, it is possible to prevent leakage current between source/drain patterns of a field-effect transistor. According to embodiments of the present disclosure, it is possible to prevent impurity diffusion from the source/drain patterns to a channel pattern of the field-effect transistor. As a result, stable performance of the field-effect transistor can be secured, and reliability of a semiconductor device can be improved.

Embodiments are set out in the following clauses:
Clause 1. A semiconductor device comprising: source/drain patterns on a substrate; a channel pattern connected to the source/drain patterns; a gate electrode on the channel pattern; and a barrier layer provided between the substrate and the source/drain patterns and between the channel pattern and the source/drain patterns, the barrier layer containing a metal oxide.
Clause 2. The semiconductor device of Clause 1, wherein at least a portion of the barrier layer includes a crystalline layer epitaxially grown from the substrate and/or the channel pattern.
Clause 3. The semiconductor device of Clause 2, wherein the substrate contains silicon, and the metal oxide contains a metal having oxygen reactivity higher than that of the silicon.
Clause 4. The semiconductor device of Clause 2 or 3, wherein the substrate contains silicon, and the metal oxide has a bandgap greater than that of the silicon.
Clause 5. The semiconductor device of Clause 4, wherein a metal of the metal oxide is aluminum or nickel.
Clause 6. The semiconductor device of any preceding Clause, wherein the barrier layer comprises: a first barrier layer provided between the substrate and the source/drain patterns; and a second barrier layer provided between the channel pattern and the source/drain patterns.
Clause 7. The semiconductor device of Clause 6, wherein the first barrier layer and the second barrier layer are integrally formed as an undivided structure.
Clause 8. The semiconductor device of Clause 6 or 7, wherein a thickness of the first barrier layer is larger than a thickness of the second barrier layer.
Clause 9. The semiconductor device of Clause 6, 7 or 8, wherein a metal concentration of the first barrier layer is greater than a metal concentration of the second barrier layer.
Clause 10. The semiconductor device of Clause 9, wherein the metal concentration of the second barrier layer is 50% or less of the metal concentration of the first barrier layer.
Clause 11. The semiconductor device of any one of Clauses 6 to 10, further comprising a metal doped layer provided on the substrate, wherein the first barrier layer is provided between the metal doped layer and the source/drain patterns.
Clause 12. The semiconductor device of Clause 11, wherein the metal doped layer contains a same metal as a metal of the metal oxide.
Clause 13. The semiconductor device of any preceding Clause, wherein at least one of the source/drain patterns comprises: a first epitaxial layer having a first impurity concentration; and a second epitaxial layer having a second impurity concentration different from the first impurity concentration.
Clause 14. The semiconductor device of Clause 13, wherein the source/drain patterns comprise: first source/drain patterns containing a P-type impurity; and second source/drain patterns containing an N-type impurity.
Clause 15. The semiconductor device of Clause 14, wherein the second source/drain patterns contain a same semiconductor element as that of the substrate, and the first source/drain patterns contain a semiconductor element having a lattice constant greater than a lattice constant of the semiconductor element of the substrate.
Clause 16. The semiconductor device of any preceding Clause, wherein the channel pattern comprises a plurality of semiconductor patterns vertically stacked and spaced apart from each other.
Clause 17. The semiconductor device of Clause 16, wherein the gate electrode surrounds each of the semiconductor patterns.
Clause 18. A semiconductor device comprising: a metal doped layer on a substrate; source/drain patterns provided on the metal doped layer; a channel pattern connected to the source/drain patterns; a gate electrode on the channel pattern; and a barrier layer surrounding a lower portion and side portions of each of the source/drain patterns, wherein the barrier layer contains an oxide of a metal having a bandgap and oxygen reactivity that are greater than those of the substrate.
Clause 19. A semiconductor device comprising: first and second transistors provided in different regions, wherein each of the first and second transistors comprises: source/drain patterns on a substrate; a channel pattern connected to the source/drain patterns; a gate electrode on the channel pattern; and a barrier layer provided between the substrate and the source/drain patterns and between the channel pattern and the source/drain patterns, the barrier layer containing a metal oxide, and wherein the source/drain patterns of the first transistor are doped with impurities of a conductivity type different from that of the source/drain patterns of the second transistor.
Clause 20. The semiconductor device of Clause 19, wherein the first transistor is a PMOS transistor and the second transistor is an NMOS transistor.

The above-described contents are specific embodiments for implementing the present disclosure. In addition to the above-described embodiments, the present disclosure will also include embodiments that can be simply designed around or easily changed. In addition, the present disclosure will also include technologies that can be implemented by being easily modified using the embodiments.

## Claims

1. A semiconductor device comprising:
source/drain patterns (SD1, SD2) on a substrate (100);
a channel pattern (CH) connected to the source/drain patterns (SD1, SD2);
a gate electrode (GE) on the channel pattern (CH); and
a barrier layer (BL) provided between the substrate (100) and the source/drain patterns (SD1, SD2) and between the channel pattern (CH) and the source/drain patterns (SD1, SD2), the barrier layer (BL) containing a metal oxide.

2. The semiconductor device of claim 1, wherein at least a portion of the barrier layer (BL) includes a crystalline layer epitaxially grown from the substrate (100) and/or the channel pattern (CH).

3. The semiconductor device of claim 2, wherein
the substrate (100) contains silicon, and
the metal oxide contains a metal having oxygen reactivity higher than that of the silicon.

4. The semiconductor device of claim 2 or 3, wherein
the substrate (100) contains silicon, and
the metal oxide has a bandgap greater than that of the silicon.

5. The semiconductor device of claim 4, wherein the metal of the metal oxide is aluminum or nickel.

6. The semiconductor device of any preceding claim, wherein
the barrier layer (BL) comprises:
a first barrier layer (BLa) provided between the substrate (100) and the source/drain patterns (SD1, SD2); and
a second barrier layer (BLb) provided between the channel pattern (CH) and the source/drain patterns (SD1, SD2).

7. The semiconductor device of claim 6, wherein the first barrier layer (BLa) and the second barrier layer (BLb) are integrally formed as an undivided structure.

8. The semiconductor device of claim 6, wherein a thickness of the first barrier layer (BLa) is larger than a thickness of the second barrier layer (BLb).

9. The semiconductor device of claim 6 or claim 8, wherein a metal concentration of the first barrier layer (BLa) is greater than a metal concentration of the second barrier layer (BLb).

10. The semiconductor device of claim 9, wherein the metal concentration of the second barrier layer (BLb) is 50% or less of the metal concentration of the first barrier layer (BLa).

11. The semiconductor device of any one of claims 6 to 10, further comprising a metal doped layer (103) provided on the substrate (100),
wherein the first barrier layer (BLa) is provided between the metal doped layer (103) and the source/drain patterns (SD1, SD2).

12. The semiconductor device of claim 11, wherein the metal doped layer (103) contains a same metal as a metal of the metal oxide.

13. The semiconductor device of any preceding claim, wherein at least one of the source/drain patterns (SD1, SD2) comprises:
a first epitaxial layer (SD1a, SD2a) having a first impurity concentration; and
a second epitaxial layer (SD1b, SD2b) having a second impurity concentration different from the first impurity concentration.

14. The semiconductor device of claim 13, wherein the source/drain patterns (SD1, SD2) comprise:
first source/drain patterns (SD1) containing a P-type impurity; and
second source/drain patterns (SD2) containing an N-type impurity.

15. The semiconductor device of claim 14, wherein
the second source/drain patterns (SD2) contain a same semiconductor element as that of the substrate (100), and
the first source/drain patterns (SD1) contain a semiconductor element having a lattice constant greater than a lattice constant of the semiconductor element of the substrate (100).
